# EUROPÄISCHE PATENTANMELDUNG

(11) **EP 0 637 197 A1**
(43) Veröffentlichungstag der Anmeldung: **01.02.1995**
(21) Anmeldenummer: 94110667.6
(22) Anmeldetag: 08.07.1994
(51) Int. Cl.: H05K 3/42

(54) **Verfahren zum Durchkontaktieren von Mehrlagenleiterplatten**

(30) Priorität: 26.07.1993 DE 4325054
(71) Anmelder: Siemens Nixdorf Informationssysteme AG, D-33106 Paderborn (DE)
(72) Erfinder: Mayer, Heinrich, Dipl.-Ing. FH, D-86179 Augsburg (DE); Merkenschlager, Hans-Hermann, Dipl.-Ing., D-86179 Augsburg (DE); Winzig, Hubert, Dipl.-Ing. FH, D-86163 Augsburg (DE); Zeidler, Wolfgang, D-86179 Augsburg (DE); Neumann, Rudolf, Dipl.-Ing., D-86830 Schwabmünchen (DE)
(74) Vertreter: Fuchs, Franz-Josef, Dr.-Ing.

(57) **Zusammenfassung**

Die Erfindung bezieht sich auf ein Verfahren zum Durchkontaktieren von Mehrlagenleiterplatten, deren Innenlagenkupferoberflächen (3) vor dem Verpressen oxydiert werden. Dieser Nachteil des großen Aufwandes von Reduktionsmitteln wird durch die Erfindung dadurch beseitigt, daß die verpreßten und gebohrten Leiterplatten vor dem Durchkontaktieren einem Reduktionsprozeß unterworfen werden. Neben der Einsparung von Reduktionsmitteln wird dadurch auch eine unterbrechungsfreie Oberfläche der Durchkontaktierungen erzielt Beim Durchkontaktieren der verpreßten und gebohrten Leiterplatten befinden sich häufig an den Kupferausschnittsstellen in den Bohrungen Unterbrechungen in der Kupferbelegung. Dieser Nachteil wird bei dem üblichen Verfahren durch Reduktion der gesamten Oxydschicht auf der Innenlage vor dem Verpressen vermieden, was jedoch einen großen Aufwand an Reduktionsmitteln bedeutet.

## Beschreibung

Die Erfindung betrifft ein Verfahren zum Durchkonutaktieren von Mehrlagenleiterplatten, deren Innenlagenkupferoberflächen vor dem Verpressen oxydiert werden.

Innenlagen von Mehrlagenleiterplatten werden vor dem Verpressen zur Verbesserung der Haftfähigkeit an den Kupferoberflächen oxydiert. Beim Durchkontaktieren der verpreßten und gebohrten Leiterplatten bilden sich häufig an den Kupferanschnittstellen in den Bohrungen Unterbrechungen in der Kupferbelegung. Grund hierfür ist ein bei chemischem Lochwandreiniger erfolgter Angriff auf den in den Bohrungen freigelegten Teil der Oxydschicht. Zur Verhinderung derartiger Unterbrechungen ist bisher nach Aufbringen der Oxydschicht auf die Innenlagen in einem gesonderten Arbeitsschritt die Oxydschicht chemisch reduziert worden. Die reduzierte Schicht ist gegen den Durchkontaktierungsprozeß unempfindlich. Dieses Verfahren hat jedoch den Nachteil, daß die Oxydschicht auf der gesamten Kupferoberfläche der Innenlagen reduziert werden muß, was mit einem erheblichen Aufwand von Chemikalien erreicht wird.

Aufgabe der vorliegenden Erfindung ist es, ein vereinfachtes Verfahren zur Durchkontaktierung von Mehrlagenleiteplatten mit oxydierter Kupferschicht der Innenlagen anzugeben.

Zur Lösung dieser Aufgabe wird gemäß der Erfindung derart verfahren, daß die verpreßten und gebohrten Leiterplatten vor dem Durchkontaktieren einem Reduktionsprozeß unterworfen werden.

Durch dieses Verfahren entfällt das Reduzieren der gesamten Kupferoberfläche der Innenlagen vor dem Verpressen. Dadurch wird eine erhebliche Einsparung von Chemikalien erreicht, da nur noch ein Bruchteil des Oxyds der Innenlagen reduziert werden muß.

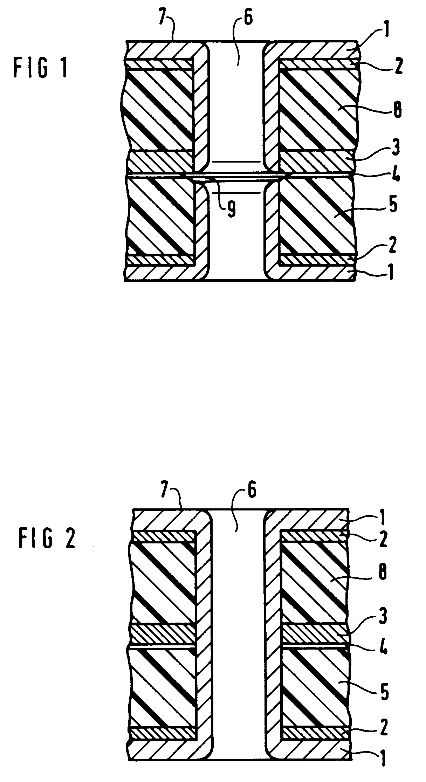

Anhand der Skizzen nach den Figuren 1 und 2 wird die Erfindung näher erläutert. Es zeigen
Figur 1 eine Mehrlagenleiterplatte mit Unterbrechung an den Kupferanschnittstellen in den Durchkontaktierungen und
Figur 2 eine Mehrlagenleiterplatte, die nach dem Verfahren nach der Erfindung hergestellt worden ist.

Der in Figur 1 schematisch dargestellte Ausschnitt aus einer Mehrlagenleiterplatte zeigt eine Durchkontaktierung 6, durch die Mehrlagenleiterplatte 7, die der Einfachheit halber nur aus zwei Lagen 5 und 8 mit den Kupferaußenlagen 2 und einer Kupferinnenlage 3 besteht, wobei die Oberfläche der Kupferinnenlage 3 eine Oxydschicht 4 aufweist. Bei den nach dem bekannten Verfahren hergestellten Mehrlagenleiterplatten treten an den Kupferschnittstellen in den Bohrungen Unterbrechungen 9 auf.

Diese Unterbrechungen werden durch das Verfahren der vorliegenden Erfindung vermieden, wie Figur 2 zeigt, wo der gleiche Ausschnitt aus einer Mehrlagenleiterplatte, wie in Figur 1 dargestellt ist. Die Lagen 5, 8 der Leiterplatten 7, sind wieder mit Kupferaußenlagen 2 versehen, auf die beim Durchkontaktieren das galvanische Kupfer 1, das sich auch in der Bohrung 6 befindet, aufgebracht wird. Auf der einen Lage 5 ist eine Kupferinnenlage 3 angeordnet, auf der sich die Oxydschicht 4 befindet, wobei jedoch entsprechend dem Verfahren nach der Erfindung die Reduktion dieser Oxydschicht nur an den Kupferanschnittstellen 9 in den Bohrungen vorgenommen wird, so daß sich beim Durchkontaktieren das galvanische Kupfer 1 gleichmäßig an den Wänden ablagert, ohne daß Unterbrechungen auftreten.

## Patentansprüche

1. Verfahren zum Durchkontaktieren von Mehrlagenleiterplatten, deren Innenlagenkupferoberflächen vor dem Verpressen oxydiert werden,
**dadurch gekennzeichnet,**
daß die verpreßten und gebohrten Leiterplatten vor dem Durchkontaktieren einem Reduktionsprozeß unterworfen werden.
